# EUROPEAN PATENT SPECIFICATION

(11) **EP 3 024 023 B1**
(45) Date of publication and mention of the grant of the patent: **19.05.2021**
(21) Application number: 14198170.4
(22) Date of filing: 16.12.2014
(51) Int. Cl.: H01L 23/40, H01L 23/367, H01L 21/48, H05K 1/02

(54) **Slat fastening assembly**
Lamellenbefestigungsanordnung
Ensemble de fixation de latte

(30) Priority: 19.11.2014 TW 103220528
(43) Date of publication of application: 25.05.2016
(73) Proprietor: Giga-Byte Technology Co., Ltd., New Taipei City 231 (TW)
(72) Inventor: Yeh, Chi-Sheng, 231 Taiwan (TW); Chen, Hsuan-How, 231 Taiwan (TW); Kao, Yung-Shun, 231 Taiwan (TW); Chang, Shih-Ho, 231 Taiwan (TW)
(74) Representative: Plasseraud IP

(56) References cited:
- JP-U- 3 187 731
- US-A1- 2003 150 597
- US-A1- 2005 108 877
- US-A1- 2007 028 955
- US-A1- 2010 097 766
- US-A1- 2014 116 671

## Description

### BACKGROUND

### Technical Field

This disclosure relates to fastening structure applied on a circuit board, in particular, to a slat fastening assembly.

### Related Art

On a circuit board, various forms of radiators are usually used in order to achieve the heat dissipation for a particular electronic component or the whole system. Moreover, on the circuit board, various fixing structures or fixing pillars are also usually used for installing attached components on the circuit board.

Sometimes, an attached component, such as an enhancing component for heat dispassion or a decorative component, is attached to the radiator, the fixing structure, or the fixing pillar. A common approach to fix the attached component is to drill a screw hole on the radiator, the fixing structure or the fixing pillar, and to drill a via hole on the attached component; through a screw running through a via hole and engaged into the corresponding screw hole, the attached component is fixed to the radiator, the fixing structure, or the fixing pillar. A tool, such as a screw driver, is required to drive the screw.

An alternative approach is to use a jig to fix the attached component to the radiator, the fixing structure or the fixing pillar. The jig can be manipulated without tools, but the jig must match the size and the configuration of the clamped object; if the clamped object replaced by another clamped object having different size and different configuration, this jig may not be suitable for the new clamped object.

US 2005/108877 A1 (PETERSON ERIC C [US]) 26 May 2005 (2005-05-26), and US 2014/116671 A1 (YU CHUN-SHENG [TW]) 1 May 2014 (2014-05-01) are pieces of prior art relevant to the present invention.

Therefore, a new approach to fix the attached component is required in this technical field.

### SUMMARY

In view of the foregoing problems, this disclosure provides a slat fastening assembly, which is able to be operated without tools.

The slat fastening assembly according to the invention is applicable to a circuit board. The slat fastening assembly includes a slat, at least one first fastening member, a base, and at least one second fastening member.

The first fastening member is disposed on the slat; the base is fixed on the circuit board. The second fastening member is disposed on the base. The first fastening member is detachably combined with the second fastening member, so that the slat is detachably combined with the base.

In one or more embodiments, the first fastening member and the second fastening member are two magnets.

In one or more embodiments, the first fastening member and the second fastening member are a magnet and a ferrous metal component.

In one or more embodiments, the first fastening member and the second fastening member are an embedded hole and a protruding part, and the protruding part is engaged within the embedded hole in a tight-fit manner.

In one or more embodiments, the protruding part is a resilient component.

In one or more embodiments, the slat has a top surface and a bottom surface, and the first fastening member is disposed on the bottom surface.

According to the present invention, the base is an air-cooled radiator.

In one or more embodiments, the base is a fixing pillar having an upper end and a lower end; the second fastening member is disposed on the upper end, while the lower end is fixed to the circuit board.

In one or more embodiments, the fixing pillar includes a screw thread disposed near the lower end; the fixing pillar is screwed into a fixing hole of the circuit board.

In one or more embodiments, the base includes a combination portion and two fixing portions, the two fixing portions respectively extend from two ends of the combination portion and are fixed on the circuit board, such that a gap exists between the combination portion and the circuit board, and the second fastening member is disposed on the combination portion.

In one or more embodiments, the first fastening member is a guide piece disposed on one side edge of the slat; the second fastening member is a sunken groove track on the base, and at least one sidewall of the sunken groove track forms a guide groove; and the guide piece slides in the guide groove, so as to combine the slat with the base.

In one or more embodiments, the slat fastening assembly further includes at least one resilient component, and the slat has a top surface and a bottom surface. The resilient component is disposed on the bottom surface.

In this disclosure, the slat is able to be detachably combined with the base. Fastening or removing the slat does not need to use any tools or additional jigs. It only requires the users to hold the slat with hands. Therefore, the users can quickly replace with the slat of different forms to achieve the purposes of enhancing heat dissipation or changing the decoration effects.

### BRIEF DESCRIPTION OF THE DRAWINGS

The present invention will become more fully understood from the detailed description given herein below for illustration only, and thus not limitative of the present invention, wherein:
FIG. 1 is an exploded view of the first embodiment of this disclosure;
FIG. 2 is a perspective view of the first embodiment of this disclosure;
FIG. 3 is a schematic cross-sectional view of the first embodiment of this disclosure;
FIG. 4 is another schematic cross-sectional view of the first embodiment of this disclosure;
FIG. 5 is an exploded view of the second embodiment of this disclosure;
FIG. 6 is a perspective view of the second embodiment of this disclosure;
FIG. 7 is a schematic cross-sectional view of the second embodiment of this disclosure;
FIG. 8 is another schematic cross-sectional view of the second embodiment of this disclosure.
FIG. 9 is an exploded view of the third embodiment of this disclosure;
FIG. 10 is a perspective view of the third embodiment of this disclosure;
FIG. 11 is a schematic cross-sectional view of the third embodiment of this disclosure;
FIG. 12 is another schematic cross-sectional view of the third embodiment of this disclosure;
FIG. 13 is an exploded view of the fourth embodiment of this disclosure;
FIG. 14 is a perspective view of the fourth embodiment of this disclosure;
FIG. 15 is a schematic cross-sectional view of the fourth embodiment of this disclosure;
FIG. 16 is a schematic cross-sectional view of the fourth embodiment of this disclosure;
FIG. 17 is an exploded view of the fifth embodiment of this disclosure;
FIG. 18 is a perspective view of the fifth embodiment of this disclosure;
FIG. 19 is a schematic cross-sectional view of the fifth embodiment of this disclosure; and
FIG. 20 is another schematic cross-sectional view of the fifth embodiment of this disclosure.

### DETAILED DESCRIPTION

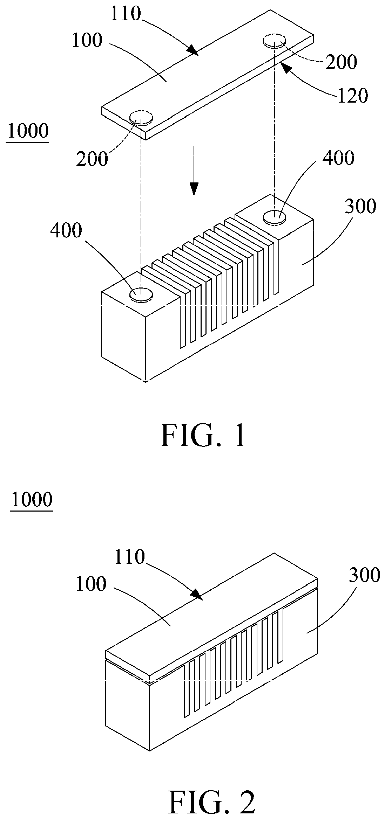

Referring to FIG. 1, FIG. 2 and FIG. 3, the first embodiment of this disclosure discloses a slat fastening assembly 1000, applicable to a circuit board 900. The slat fastening assembly 1000 includes a slat 100, one or more first fastening members 200, a base 300, and one or more second fastening members 400.

As shown in FIG. 1, FIG. 2, and FIG. 3, the slat 100 includes a top surface 110 and a bottom surface 120. The slat 100 is a heat sink component or a decorative component. When the slat 100 is a heat sink component, the material of the slat 100 is made of metal with high thermal conductivity, and fins or other structures of enhancing heat dissipation can be further disposed on the top surface 110. When the slat 100 is a decorative component, the material of the slat 100 is plastics or metal, and decorative structure or decorative patterns can be further disposed on the top surface 110.

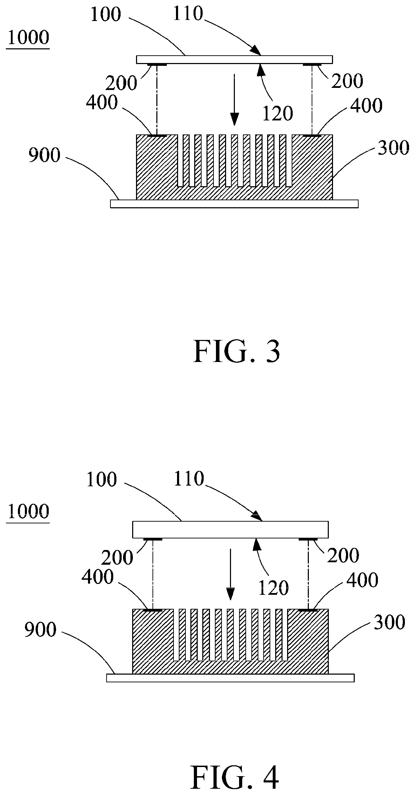

As shown in FIG. 1 and FIG. 3, the first fastening member 200 is disposed on the bottom surface 120 of the slat 100. The quantity of the first fastening member 200 can be one or multiple.

As shown in FIG. 1, FIG. 2 and FIG. 3, the base 300 is fixed on the circuit board 900. The base 300 can be any structure fixed on the circuit board 900. In the first embodiment, the base 300 is an air-cooled radiator having plural heat dissipation fins. The implementation of the base 300 is not limited to the radiator. The base 300 can be a fixing pillar.

As shown in FIG. 1 and FIG. 3, the second fastening member 400 is disposed on the base 300. The first fastening member 200 is detachably combined with the second fastening member 400, such that the slat 100 is detachably combined with the base 300. When the slat 100 is a heat sink component, the combination of the slat 100 and the base 300 enhances the heat dissipation effect of the circuit board 900. When the slat 100 is the decorative component, the slat 100 provides additional decoration for the circuit board 900.

In the first embodiment, the first fastening member 200 and the second fastening member 400 are two magnets, the combination of a magnet and a ferrous metal component. Through magnetism attracts, the first fastening member 200 and the second fastening member attract each other. The combination relationship between the first fastening member 200 and the second fastening member 400 can be the combination in other forms, for example, the combination in a tight-fit manner.

As described above, the configuration, the attached structure, the size, etc. of the slat 100, are not limited in this disclosure. For example, in FIG. 4, the thickness of the slat 100 can be arbitrarily increased or decreased, so as to enhance the heat dissipation effect for the circuit board 900, or change the decorative effect provided for the circuit board 900.

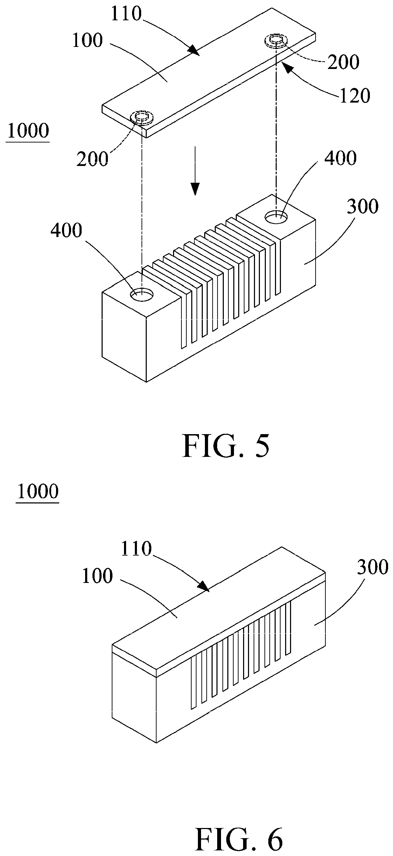

Referring to FIG. 5, FIG. 6 and FIG. 7, the second embodiment of this disclosure discloses a slat fastening assembly 1000, applicable to a circuit board 900. The slat fastening assembly 1000 includes a slat 100, one or more first fastening members 200, a base 300, and one or more second fastening members 400.

The second embodiment is approximately the same as the first embodiment, except that in the second embodiment the first fastening member 200 and the second fastening member 400 are the combination of the protruding part and the embedded hole. The protruding part is a resilient component, such as the rubber plug. The protruding part is engaged within the embedded hole in a tight-fit manner. In the drawings of this disclosure, it appears that the first fastening member 200 is a protruding part and the second fastening member 400 is the embedded hole. Alternatively, the first fastening member 200 is an embedded hole and the second fastening member 400 is a protruding part.

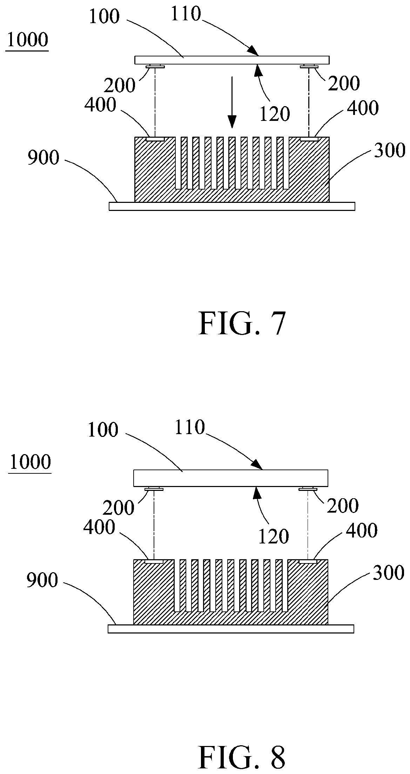

Likewise, the configuration, the attached structure, the size, etc. of the slat 100, are not limited in the second embodiment. For example, in FIG. 8, the thickness of the slat 100 can be arbitrarily increased or decreased.

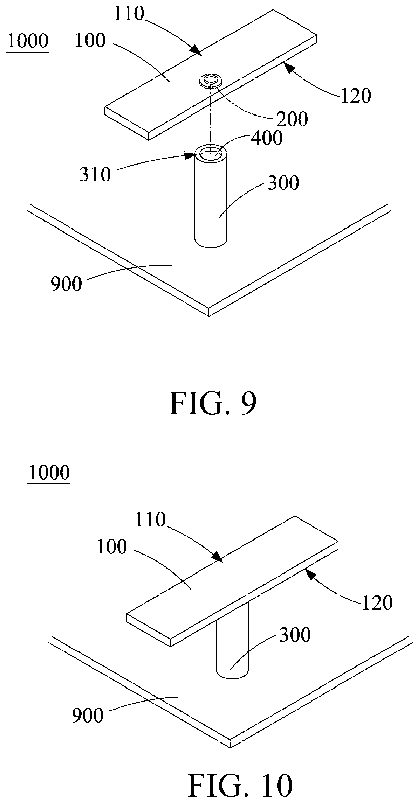

Referring to FIG. 9, FIG. 10 and FIG. 11, the third embodiment of this disclosure discloses a slat fastening assembly 1000, applicable to a circuit board 900. The slat fastening assembly 1000 comprises a slat 100, one or more first fastening members 200, a base 300, and one or more second fastening members 400.

As shown in FIG. 9, FIG. 10 and FIG. 11, the base 300 of the third embodiment is a fixing pillar, including an upper end 310 and a lower end 320. The second fastening member 400 is disposed on the upper end 310 of the base 300, such that the slat 100 is detachably combined with the upper end 310 of the base 300 through the first fastening member 200 and the second fastening member 400. The lower end 320 is fixed on the circuit board 900. In detail, the fixing pillar includes a screw thread disposed near the lower end 320, and the circuit board 900 has a fixing hole 910. The lower end 320 is screwed into the fixing hole 910, so as to be fixed to the circuit board 900, and then the base 300 is fixed on the circuit board 900.

Similarly, in the third embodiment, the first fastening member 200 and the second fastening member 400 are two magnets, the combination of a magnet and a ferrous metal component. Through magnetism attracts, the first fastening member 200 and the second fastening member attract each other. The first fastening member 200 and the second fastening member 400 are the combination of the protruding part and the embedded hole, and the protruding part is a resilient component, such as the rubber plug. The protruding part is engaged within the embedded hole in a tight-fit manner.

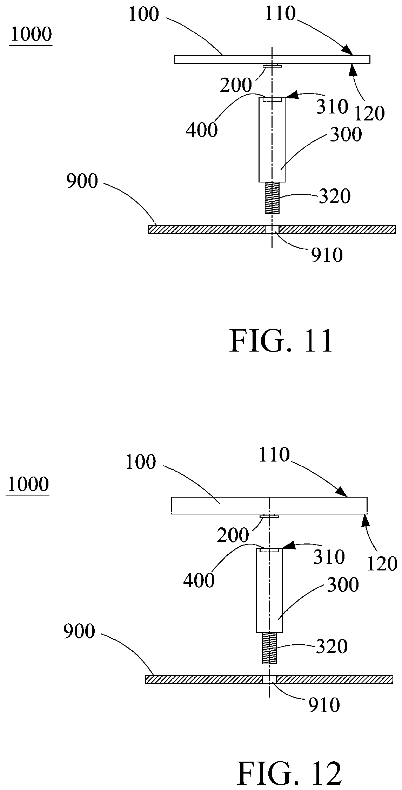

Similarly, the configuration, the attached structure, the size, etc. of the slat 100, are not limited in the third embodiment. For example, in FIG. 12, the thickness of the slat 100 can be arbitrarily increased or decreased.

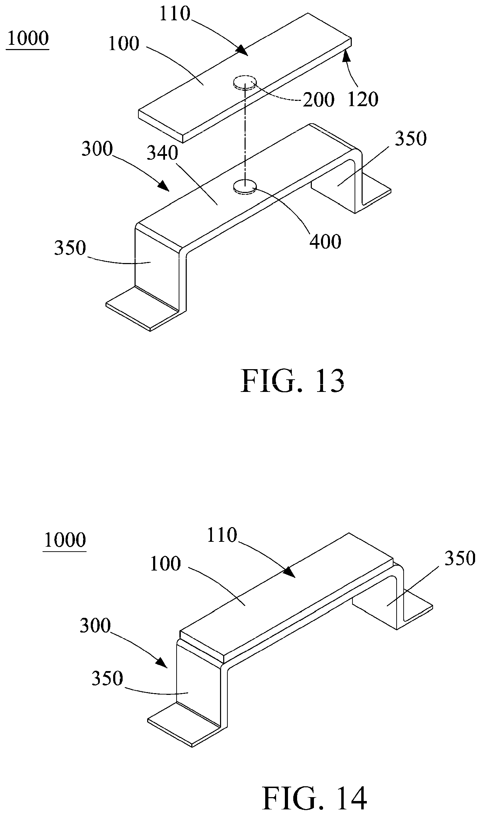

As shown in FIG. 13, FIG. 14 and FIG. 15, the base 300 in the fourth embodiment is a fixing structure, including a combination portion 340 and two fixing portions 350. The two fixing portions 350 extend from two ends of the combination portion 340 and are fixed on the circuit board 900, such that a gap exists between the combination portion 340 and the circuit board 900. The second fastening member 400 is disposed on the combination portion 340 of the base 300, such that the slat 100 is detachably combined with the combination portion 340 of the base 300 through the first fastening member 200 and the second fastening member 400.

Similarly, in the fourth embodiment, the first fastening member 200 and the second fastening member 400 are two magnets, the combination of a magnet and a ferrous metal component. Through magnetism attracts, the first fastening member 200 and the second fastening member 400 attract each other. The first fastening member 200 and the second fastening member 400 are the combination of a protruding part and an embedded hole, and the protruding part is a resilient component, such as the rubber plug. The protruding part combines within the embedded hole in a tight-fit manner.

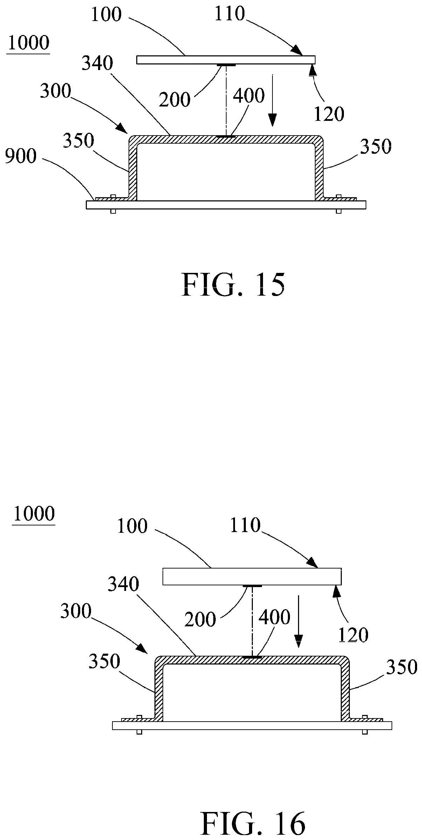

Similarly, the configuration, the attached structure, the size, etc. of the slat 100, are not limited in the fourth embodiment. For example, in FIG. 16, the thickness of the slat 100 can be arbitrarily increased or decreased.

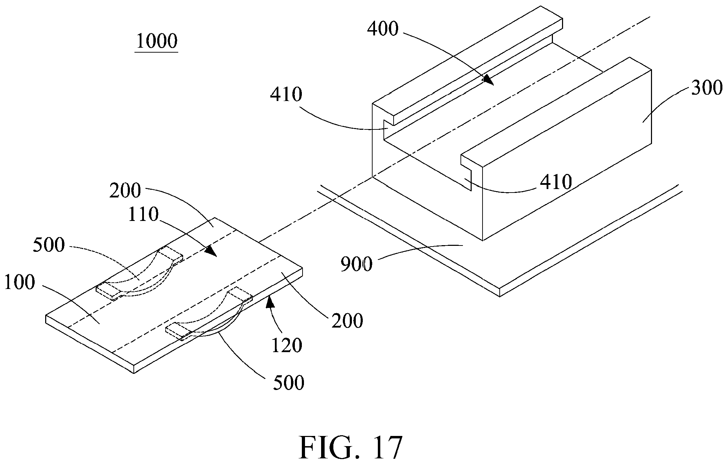

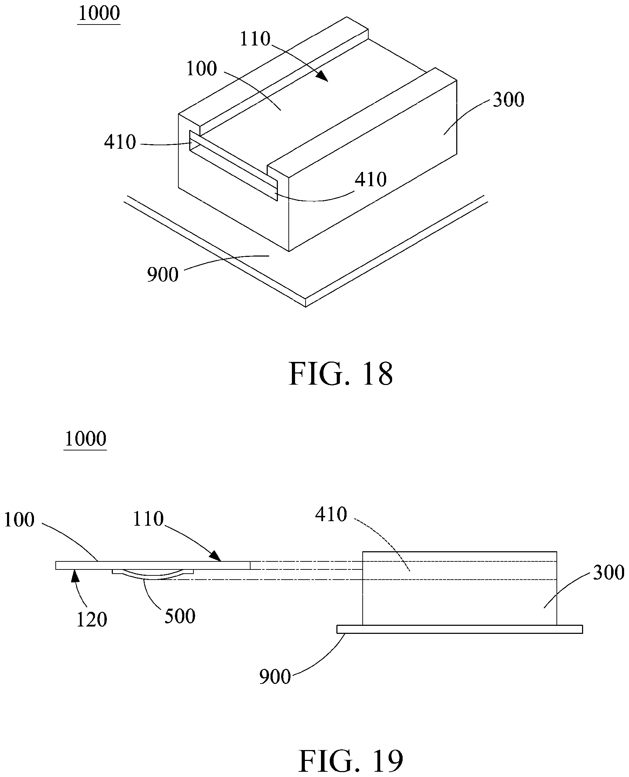

Referring to FIG. 17, FIG. 18 and FIG. 19, the fifth embodiment of this disclosure discloses a slat fastening assembly 1000, applicable to a circuit board 900. The slat fastening assembly 1000 includes a slat 100, two first fastening members 200, a base 300, and a second fastening member 400.

As shown in FIG. 17, FIG. 18 and FIG. 19, the first fastening members 200 are guide pieces disposed on two side edges of the slat 100. The second fastening member 400 is a sunken groove track formed on the base 300, and two opposite sidewalls of the sunken groove track are formed with guide groove 410. Each guide piece respectively slides in one of the guide grooves 410, such that the slat 100 is detachably combined with the base 300. Furthermore, the slat fastening assembly 1000 further includes at least one resilient component 500 disposed on the bottom surface 120 of the slat 100. When the slat 100 is combined with the base 300,

The resilient component 500 presses against the bottom surface of the sunken groove track, such that the guide pieces contact the inner wall of the guide grooves 410 tightly, so as to prevent the slat 100 sliding relative to the base 300.

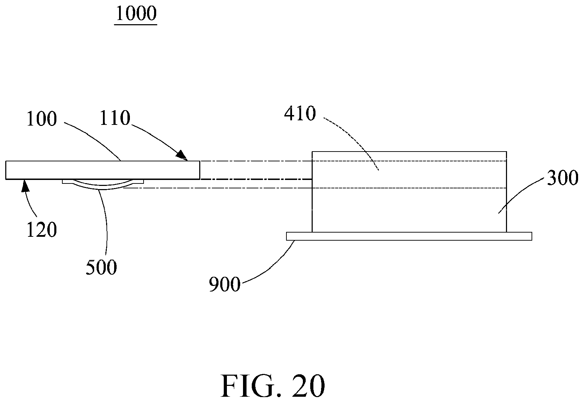

Similarly, the configuration, the attached structure, the size, etc. of the slat 100, are not limited in the fifth embodiment. For example, in FIG. 20, the thickness of the slat 100 can be arbitrarily increased or decreased.

In this disclosure, the slat is able to be detachably combined with the base. Fastening or removing the slat does not need to use any tools or additional jigs. It only requires the users to hold the slat with hands. Therefore, the users can quickly replace with the slat of different forms to achieve the purposes of enhancing heat dissipation or changing the decoration effects.

## Claims

1. A slat fastening assembly (1000), applicable to a circuit board (900), comprising:
at least one first fastening member (200);
a base (300), configured to be fixed on the circuit board (900); and
at least one second fastening member (400), disposed on the base (300);
**characterized in that** the slat fastening assembly (1000) further comprises:
a slat (100);
wherein the at least one first fastening member (200) is disposed on the slat (100),
wherein the base (300) is an air-cooled radiator, and
wherein the first fastening member (200) is detachably combined with the second fastening member (400), such that the slat (100) is detachably combined with the base (300).

2. The slat fastening assembly (1000) as claimed in Claim 1, wherein the first fastening member (200) and the second fastening member (400) are magnets.

3. The slat fastening assembly (1000) as claimed in Claim 1, wherein the first fastening member (200) and the second fastening member (400) are a magnet and a ferrous metal component.

4. The slat fastening assembly (1000) as claimed in Claim 1, wherein the first fastening member (200) and the second fastening member (400) are an embedded hole and a protruding part, and the protruding part is engaged within the embedded hole in a tight-fit manner.

5. The slat fastening assembly (1000) as claimed in Claim 4, wherein the protruding part is a resilient component.

6. The slat fastening assembly (1000) as claimed in Claim 1, wherein the slat (100) includes a top surface (110) and a bottom surface (120), and the first fastening member (200) is disposed on the bottom surface (120).

7. The slat fastening assembly (1000) as claimed in Claim 6, wherein the base (300) is a fixing pillar including an upper end (310) and a lower end (320); the second fastening member (400) is disposed on the upper end (310), while the lower end (320) is fixed to the circuit board (900).

8. The slat fastening assembly (1000) as claimed in Claim 7, wherein fixing pillar includes a screw thread disposed near the lower end (320), the fixing pillar is screwed into a fixing hole of the circuit board (900).

9. The slat fastening assembly (1000) as claimed in Claim 6, wherein the base (300) includes a combination portion (340) and two fixing portions (350), the two fixing portions (350) respectively extend from two ends of the combination portion (340) and are fixed on the circuit board (900), such that a gap exists between the combination portion (340) and the circuit board (900), and the second fastening member (400) is disposed on the combination portion (340).

10. The slat fastening assembly (1000) as claimed in Claim 1, wherein:
the first fastening member (200) is a guide piece disposed on one side edge of the slat (100) ;
the second fastening member (400) is a sunken groove track on the base (300), and at least one sidewall of the sunken groove track is formed with a guide groove; and
the guide piece slides in the guide groove, so as to combine the slat (100) with the base (300).

11. The slat fastening assembly (1000) as claimed in Claim 10, further comprising at least one resilient component (500), and the slat (100) having a top surface (110) and a bottom surface (120), the resilient component disposed on the bottom surface (120).

## Patentansprüche

1. Lamellenbefestigungsanordnung (1000), die auf eine Leiterplatte (900) anwendbar ist, die aufweist:
wenigstens ein erstes Befestigungselement (200);
eine Basis (300), die konfiguriert ist, um auf der Leiterplatte (900) befestigt zu werden; und
wenigstens ein zweites Befestigungselement (400), das auf der Basis (300) angeordnet ist;
**dadurch gekennzeichnet, dass** die Lamellenbefestigungsanordnung (1000) ferner aufweist:
eine Lamelle (100);
wobei das wenigstens eine erste Befestigungselement (200) auf der Lamelle (100) angeordnet ist,
wobei die Basis (300) ein luftgekühlter Strahler ist, und
wobei das erste Befestigungselement (200) abnehmbar mit dem zweiten Befestigungselement (400) kombiniert ist, so dass die Lamelle (100) abnehmbar mit der Basis (300) gekoppelt ist.

2. Lamellenbefestigungsanordnung (1000) nach Anspruch 1, wobei das erste Befestigungselement (200) und das zweite Befestigungselement (400) Magnete sind.

3. Lamellenbefestigungsanordnung (1000) nach Anspruch 1, wobei das erste Befestigungselement (200) und das zweite Befestigungselement (400) ein Magnet und eine eisenhaltige Metallkomponente sind.

4. Lamellenbefestigungsanordnung (1000) nach Anspruch 1, wobei das erste Befestigungselement (200) und das zweite Befestigungselement (400) ein eingebettetes Loch und ein vorstehender Teil sind, und wobei der vorstehende Teil mit dem eingebetteten Loch in einer formschlüssigen Weise in Eingriff ist.

5. Lamellenbefestigungsanordnung (1000) nach Anspruch 4, wobei der vorstehende Teil eine elastische Komponente ist.

6. Lamellenbefestigungsanordnung (1000) nach Anspruch 1, wobei die Lamelle (100) eine obere Oberfläche (110) und eine untere Oberfläche (120) umfasst und das erste Befestigungselement (200) auf der unteren Oberfläche (120) angeordnet ist.

7. Lamellenbefestigungsanordnung (1000) nach Anspruch 6, wobei die Basis (300) eine Befestigungsstütze ist, die ein oberes Ende (310) und ein unteres Ende (320) umfasst; wobei das zweite Befestigungselement (400) auf dem oberen Ende (310) angeordnet ist, während das untere Ende (320) an der Leiterplatte (900) befestigt ist.

8. Lamellenbefestigungsanordnung (1000) nach Anspruch 7, wobei die Befestigungsstütze ein Schraubgewinde umfasst, das nahe dem unteren Ende (320) angeordnet ist, wobei die Befestigungsstütze in ein Befestigungsloch der Leiterplatte (900) geschraubt wird.

9. Lamellenbefestigungsanordnung (1000) nach Anspruch 6, wobei die Basis (300) einen Kombinationsabschnitt (340) und zwei Befestigungsabschnitte (350) umfasst, wobei die zwei Befestigungsabschnitte (350) sich jeweils von zwei Enden des Kombinationsabschnitts (340) erstrecken und auf der Leiterplatte (900) befestigt sind, so dass eine Lücke zwischen dem Kombinationsabschnitt (340) und der Leiterplatte (900) vorhanden ist, und das zweite Befestigungselement (400) auf dem Kombinationsabschnitt (340) angeordnet ist.

10. Lamellenbefestigungsanordnung (1000) nach Anspruch 1, wobei:
das erste Befestigungselement (200) ein Führungsstück ist, das auf einem Seitenrand der Lamelle (100) angeordnet ist;
das zweite Befestigungselement (400) eine versenkte Rillenspur auf der Basis (300) ist und wenigstens eine Seitenwand der versunkenen Rillenspur mit einer Führungsrille ausgebildet ist; und
das Führungsstück in der Führungsrille gleitet, um die Lamelle (100) mit der Basis (300) zu kombinieren.

11. Lamellenbefestigungsanordnung (1000) nach Anspruch 10, die ferner wenigstens eine elastische Komponente (500) aufweist, und wobei die Lamelle (100) eine obere Oberfläche (110) und eine untere Oberfläche (120) hat, wobei die elastische Komponente auf der unteren Oberfläche (120) angeordnet ist.

## Revendications

1. Ensemble d'assemblage de latte (1000), applicable à une carte de circuit (900), comprenant :
au moins un premier organe d'assemblage (200) ;
une base (300), configurée pour être fixée sur la carte de circuit (900) ; et
au moins un second organe d'assemblage (400), disposé sur la base (300) ; **caractérisé en ce que** l'ensemble d'assemblage de latte (1000) comprend en outre :
une latte (100) ;
dans lequel l'au moins un premier organe d'assemblage (200) est disposé sur la latte (100),
dans lequel la base (300) est un radiateur refroidi par air, et
dans lequel le premier organe d'assemblage (200) est combiné de manière détachable avec le second organe d'assemblage (400), de sorte que la latte (100) soit combinée de manière détachable avec la base (300).

2. Ensemble d'assemblage de latte (1000) selon la revendication 1, dans lequel le premier organe d'assemblage (200) et le second organe d'assemblage (400) sont des aimants.

3. Ensemble d'assemblage de latte (1000) selon la revendication 1, dans lequel le premier organe d'assemblage (200) et le second organe d'assemblage (400) sont un aimant et un composant métallique ferreux.

4. Ensemble d'assemblage de latte (1000) selon la revendication 1, dans lequel le premier organe d'assemblage (200) et le second organe d'assemblage (400) sont un trou intégré et une partie en saillie, et la partie en saillie est mise en prise à l'intérieur du trou intégré d'une manière à ajustement serré.

5. Ensemble d'assemblage de latte (1000) selon la revendication 4, dans lequel la partie en saillie est un composant élastique.

6. Ensemble d'assemblage de latte (1000) selon la revendication 1, dans lequel la latte (100) comporte une surface de dessus (110) et une surface de dessous (120), et le premier organe d'assemblage (200) est disposé sur la surface de dessous (120).

7. Ensemble d'assemblage de latte (1000) selon la revendication 6, dans lequel la base (300) est un pilier de fixation comportant une extrémité supérieure (310) et une extrémité inférieure (320) ; le second organe d'assemblage (400) est disposé sur l'extrémité supérieure (310), tandis que l'extrémité inférieure (320) est fixée à la carte de circuit (900).

8. Ensemble d'assemblage de latte (1000) selon la revendication 7, dans lequel un pilier de fixation comporte un filet de vis disposé près de l'extrémité inférieure (320), le pilier de fixation est vissé dans un trou de fixation de la carte de circuit (900).

9. Ensemble d'assemblage de latte (1000) selon la revendication 6, dans lequel la base (300) comporte une portion de combinaison (340) et deux portions de fixation (350), les deux portions de fixation (350) s'étendent respectivement à partir de deux extrémités de la portion de combinaison (340) et sont fixées sur la carte de circuit (900), de sorte qu'un espace existe entre la portion de combinaison (340) et la carte de circuit (900), et le second organe d'assemblage (400) est disposé sur la portion de combinaison (340).

10. Ensemble d'assemblage de latte (1000) selon la revendication 1, dans lequel :
le premier organe d'assemblage (200) est une pièce de guidage disposée sur un bord latéral de la latte (100) ;
le second organe d'assemblage (400) est une piste en rainure creusée sur la base (300), et au moins une paroi latérale de la piste en rainure creusée est formée avec une rainure de guidage ; et
la pièce de guidage coulisse dans la rainure de guidage, de façon à combiner la latte (100) avec la base (300).

11. Ensemble d'assemblage de latte (1000) selon la revendication 10, comprenant en outre au moins un composant élastique (500), et la latte (100) ayant une surface de dessus (110) et une surface de dessous (120), le composant élastique étant disposé sur la surface basse (120).
